# EUROPÄISCHE PATENTSCHRIFT

(11) **EP 1 374 397 B1**
(45) Veröffentlichungstag und Bekanntmachung des Hinweises auf die Patenterteilung: **07.03.2007**
(21) Anmeldenummer: 01962670.4
(22) Anmeldetag: 21.08.2001
(51) Int. Cl.: H03G 3/30

(54) **EMPFANGSSCHALTUNG FÜR MOBILFUNKEMPFÄNGER MIT AUTOMATISCHER VERSTÄRKUNGSSTEUERUNG**
RECEIVER CIRCUIT FOR MOBILE RADIO RECEIVERS WITH AUTOMATIC AMPLIFICATION CONTROL
CIRCUIT DE RECEPTION POUR RECEPTEUR RADIO MOBILE A REGLAGE AUTOMATIQUE DE GAIN

(30) Priorität: 05.09.2000 DE 10043744
(43) Veröffentlichungstag der Anmeldung: 02.01.2004
(73) Patentinhaber: Infineon Technologies AG, 81669 München (DE)
(72) Erfinder: BRÜCKMANN, Dieter, 40670 Meerbusch (DE); NEUBAUER, André, 47807 Krefeld (DE)
(74) Vertreter: Lange, Thomas
(86) Internationale Anmeldenummer: PCT/DE2001/003233
(87) Internationale Veröffentlichungsnummer: WO 2002/021686

(56) Entgegenhaltungen:
- EP-A- 0 814 568
- WO-A-00/31867
- US-A- 5 982 821
- PATENT ABSTRACTS OF JAPAN vol. 1999, no. 11, 30. September 1999 (1999-09-30) & JP 11 154988 A (MATSUSHITA ELECTRIC IND CO LTD), 8. Juni 1999 (1999-06-08)

## Beschreibung

Die Erfindung betrifft eine Empfangsschaltung für einen Mobilfunkempfänger, insbesondere ein schnurloses Telefon, die mit einem steuerbaren Verstärker variabler Verstärkung ausgerüstet ist. Ferner betrifft die Erfindung ein Verfahren zum Verarbeiten eines empfangenen Signals in einem Mobilfunkempfänger.

Durch die Weiterentwicklung der mobilen Kommunikationssysteme, u.a. hinsichtlich eines flexibleren Dienstangebots, werden neue Anforderungen an die zukünftigen Endgeräte und an deren Systemkomponenten gestellt. Insbesondere wird eine höhere Flexibilität, geringerer Leistungsverbrauch, kleinere Abmessungen und geringere Kosten gefordert.

Eine Möglichkeit, diesen Anforderungen gerecht zu werden, besteht darin, die analoge Signalverarbeitung, die in heutigen Mobilfunkempfängern überwiegend zum Einsatz kommt, weitestgehend durch digitale Signalverarbeitung zu ersetzen. So ist es durch die Leistungssteigerung der Digitaltechnik in den letzten Jahren möglich geworden, auch höherfrequente Zwischenfrequenzsignale digital weiter zu verarbeiten, wodurch der Anteil der Analogfunktionen im Hochfrequenzteil des Empfängers deutlich reduziert werden kann. Generell führt die zunehmende Verlagerung von Signalverarbeitungsaufgaben in den Digitalbereich zu einer besseren Integrierbarkeit und Flexibilität des Systemkonzepts, einer Verbesserung der Langzeitstabilität sowie zu einer reduzierten Anzahl von Abgleichpunkten bei der Optimierung des Empfängers.

In diesem Zusammenhang ist es bereits bekannt, auf eine Kanalselektion im Analogbereich zu verzichten, stattdessen das breitbandige Zwischenfrequenzsignal zu digitalisieren und die Kanalselektion mittels digitaler Filter im Digitalbereich vorzunehmen.

Den bereits genannten Systemvorteilen einer solchen Lösung stehen jedoch auch Nachteile gegenüber. Bei der Umsetzung eines breitbandigen und hochfrequenten Zwischenfrequenzsignals in den Digitalbereich ist ein erheblicher Zusatzaufwand für den Analog-Digital-Umsetzer erforderlich. Dieser muß bei der Digitalisierung des breitbandigen Zwischenfrequenzsignals hohen Dynamik- und Bandbreitanforderungen gerecht werden.

Um den hohen Bandbreiteanforderungen gerecht zu werden, ist es bereits bekannt, Analog-Digital-Wandler einzusetzen, die nach dem Flash-Verfahren arbeiten. Nachteilig ist, daß dieser Wandlertyp sehr aufwendig und teuer ist.

Zur Reduzierung der Dynamikanforderungen an den Analog-Digital-Umsetzer (es können Dynamikunterschiede bis zu 100 dB im Empfangssignal auftreten) ist es bereits bekannt, eine automatische Verstärkungssteuerung AGC (Automatic Gain Control) im Analogteil zu realisieren. Die AGC bewirkt, daß das Eingangssignal des Analog-Digital-Umsetzers stets auf einen optimalen Pegel eingestellt wird. Nachteilig ist, daß auch die AGC einen erheblichen Implementierungsaufwand erfordert.

Bei einer AGC erfolgt die Signalstärkenschätzung im Bereich der analogen Signalverarbeitung, d.h. im Signalweg vor der Analog-Digital-Umsetzerstufe. Eine bekannte Modifikation einer AGC ist die PGC (programmable gain control). Bei einer PGC wird die Verstärkungseinstellung aus einem digitalen Steuerwort abgeleitet, welches von einem Signalstärkenschätzer ausgegeben wird, welcher im digitalen Signalverarbeitungsbereich angeordnet ist.

Es ist ein Mobilfunk-Umsetzerbaustein der Bezeichnung HSP50214B der Firma HARRIS Semiconductor (Intersil) bekannt, der eine PGC aufweist und die Kanalselektion im digitalen Signalverarbeitungsbereich (mittels digitaler Filter) vornimmt. Die PGC ist aus einer Kaskade bestehend aus 36 Einzelverstärkerstufen jeweils einer Verstärkung von 2 dB aufgebaut, die einzeln zu- bzw. abschaltbar sind. Die Signalstärkenschätzung erfolgt im digitalen Bereich am Gesamtsignal, d.h. vor der Kanalselektion.

Nachteilig bei diesem Baustein ist vor allem der hohe Realisierungsaufwand der PGC. Weitere Nachteile sind in der ebenfalls aufwendigen Realisierung der externen Änalog-Digital-Umsetzerstufe und der Digitalfilteranordnung zu sehen.

In der Druckschrift US 6,005,506 A ist eine Empfangsschaltung für einen Mobilfunkempfänger offenbart, bei welcher im Signalweg ein steuerbarer Verstärker mit variabler Verstärkung, eine Analog-Digital-Umsetzerstufe, eine Digital-Filteranordnung zur Kanalselektion und ein Signalstärkenschätzer zur Ermittlung der Signalstärke im selektierten Nutzkanal angeordnet sind. Der Verstärker ist in Abhängigkeit von der von dem Signalstärkenschätzer ermittelten Nutzkanal-Signalstärke steuerbar.

In der Druckschrift JP 11-261433 ist ebenfalls eine Empfangsschaltung für einen Mobilfunkempfänger offenbart. Die Empfangsschaltung umfasst einen steuerbaren Verstärker 32, eine Analog-Digital-Umsetzerstufe 11-1 und 11-2, eine DigitalFilteranordnung 12-1 bis 12-3 sowie einen Signalstärkenschätzer 104. Eine Auswerteeinrichtung 105 stellt die Verstärkung des Verstärkers 32 anhand des geschätzten Werts der Signalstärke im selektierten Nutzkanal ein. Die Signalfilteranordnung 12-1 bis 12-3 besteht aus Bandpaßfiltern zur Kanalselektion.

Der Erfindung liegt die Aufgabe zugrunde, eine Empfangsschaltung für einen Mobilfunkempfänger mit einer Kanalselektion im digitalen Signalverarbeitungsbereich anzugeben, wobei gewährleistet sein soll, daß das am Eingang der Analog-Digital-Umsetzerstufe anliegende Signal die Analog-Digital-Umsetzerstufe nicht übersteuert. Ferner soll ein entsprechendes Verfahren zum Verarbeiten eines empfangenen Signals in einem Mobilfunkempfänger angegeben werden.

Die der Erfindung zugrunde liegende Aufgabe wird durch die Merkmale der unabhängigen Ansprüche gelöst.

Dadurch, daß für die Einstellung einer geeigneten Verstärkung des steuerbaren Verstärkers eine Information zur Verfügung steht, die die Signalstärke im Nutzkanal betrifft, kann eine gezieltere, d.h. besser an die tatsächlichen Erfordernisse angepaßte Verstärkungs-Nachstellung im Verstärker vorgenommen werden.

Beispielsweise kann es vorkommen, daß die Signalstärke des breitbandigen Eingangssignals sinkt, während die Signalstärke des Nutzkanal-Signals konstant bleibt, nur unwesentlich abnimmt oder sich sogar erhöht. In diesen Fällen kann eine Nachstellung des Verstärkers zum Zwecke einer Pegelanpassung unterbleiben. Wenn andererseits eine die Signalstärke im Nutzkanal betreffende Information nicht verfügbar ist, muß bei jedem Abfallen der Gesamtsignalstärke die Verstärkung sofort nachgeregelt werden, weil davon ausgegangen werden muß, daß auch das kanalselektierte Nutzsignal von dem Energieverlust betroffen ist.

Im Ergebnis wird durch die Erfindung eine aufwandsgünstige Realisierung des Verstärkers ermöglicht, wobei die Schaltung ein sehr gutes Regelverhalten aufweist.

Eine vorteilhafte Ausführungsform der erfindungsgemäßen Empfangsschaltung kennzeichnet sich dadurch, daß der steuerbare Verstärker, insbesondere PGC, aus mehreren Verstärkerstufen aufgebaut ist, daß die Empfangsschaltung eine Auswerteeinrichtung umfaßt, der die von dem Signalstärkenschätzer ermittelte Nutzkanal-Signalstärke mitgeteilt wird, und daß eine Zuschaltung einer Verstärkerstufe immer dann vorgenommen wird, wenn die Auswerteeinrichtung feststellt, daß ein vorgegebenes Signal-zu-Rauschverhältnis im Empfangssignal unterschritten wird. Durch diese Form der Pegelanpassung wird erreicht, daß die Zuschaltung einer weiteren Verstärkerstufe des Verstärkers nur dann angefordert wird, wenn sie aus Gründen einer zu geringen Signalqualität (ausgedrückt durch das Signal-zu-Rauschverhältnis) auch tatsächlich benötigt wird. Dadurch wird erreicht, daß eine minimale Anzahl von Verstärkungs-Umschaltpunkten über den gesamten Dynamikbereich auftreten. Dies wiederum ermöglicht es, die Anzahl der Verstärkungsstufen des Verstärkers zu minimieren. Da der Realisierungsaufwand und die Kosten des Verstärkers (z.B. PGC) von der Anzahl seiner Stufen bestimmt wird, ermöglicht dies die Implementierung einer ausgesprochen kostengünstigen Hardware für die Pegelanpassung vor der Analog-Digital-Umsetzung.

Ferner ist dafür zu sorgen, daß das am Eingang der Analog-Digital-Umsetzerstufe anliegende breitbandige Signal die Analog-Digital-Umsetzerstufe nicht übersteuert. Zu diesem Zweck ist es erforderlich, die am Eingang des Analog-Digital-Umsetzers auftretende Signalstärke zu bewerten. Gemäß der Erfindung wird dieser Schutz vor einer Übersteuerung der Analog-Digital-Umsetzerstufe dadurch erreicht, daß die Empfangsschaltung ferner ein Speichermittel aufweist, in welchem Signalstärkenwerte für den Nutzkanal und für Nachbarkanäle abspeicherbar sind, und daß die Auswerteeinrichtung die in dem Speichermittel abgelegten Signalstärkenwerte auslesen kann. Der Vorteil dieser Maßnahme besteht darin, daß ein derartiges Speichermittel sowie die in diesem Speichermittel abgespeicherten Informationen (z.B. Leistungs- oder Signalpegelwerte des Nutzkanals und der Nachbarkanäle) bei den meisten digitalen Mobilfunkempfängern (z.B. bei GSM-, DECT- und Bluetooth-Empfängern) aus anderen Gründen, die später erläutert werden, bereits vorhanden sind. Dadurch, daß die Auswerteeinrichtung Zugriff auf die in dem Speichermittel abgelegten Signalstärkenwerte hat, und diese Werte in geeigneter Weise für die Steuerung des Verstärkers berücksichtigen kann, kann ein zusätzlicher Signalstärkenschätzer vor (im Falle eines AGCs) oder hinter (im Falle eines PGCs) der Analog-Digital-Umsetzerstufe entfallen.

Vorzugsweise umfaßt der steuerbare Verstärker zwischen drei und sechs, insbesondere vier, Verstärkerstufen.

Eine weitere vorteilhafte Ausgestaltung der Erfindung kennzeichnet sich dadurch, daß die Analog-Digital-Umsetzerstufe durch einen Delta-Sigma-Umsetzer realisiert ist. Dieser Wandlertyp zeichnet sich durch einen reduzierten Realisierungsaufwand im Vergleich zu dem üblicherweise verwendeten Flash-Digital-Analog-Umsetzer aus.

Weitere vorteilhafte Ausgestaltungen der Erfindung sind in den Unteransprüchen angegeben.

Die Erfindung wird nachfolgend anhand eines Ausführungsbeispiels unter Bezugnahme auf die Zeichnung erläutert; in dieser zeigt:
- Fig. 1: eine schematische Schaltbilddarstellung einer erfindungsgemäßen Empfangsschaltung;
- Fig. 2: eine schematische Schaltbilddarstellung des Ausschnitts A aus Fig. 1 in größerem Detail;
- Fig. 3a: ein Schaubild, in welchem das Signal-zu-Rauschverhältnis im Nutzkanal über dem Pegel des Eingangssignals für die PGC aufgetragen ist;
- Fig. 3b: ein Schaubild, in welchem die Pegel des Gesamtsignals, des Nutzsignals und des Rauschsignals im Nutzkanal hinter der PGC über dem Pegel des Eingangssignals für die PGC aufgetragen sind; und
- Fig. 4: eine Tabelle, in welcher Signalpegelwerte für die verfügbaren Frequenzbänder bezüglich eines bestimmten Zeitschlitzes angegeben sind.

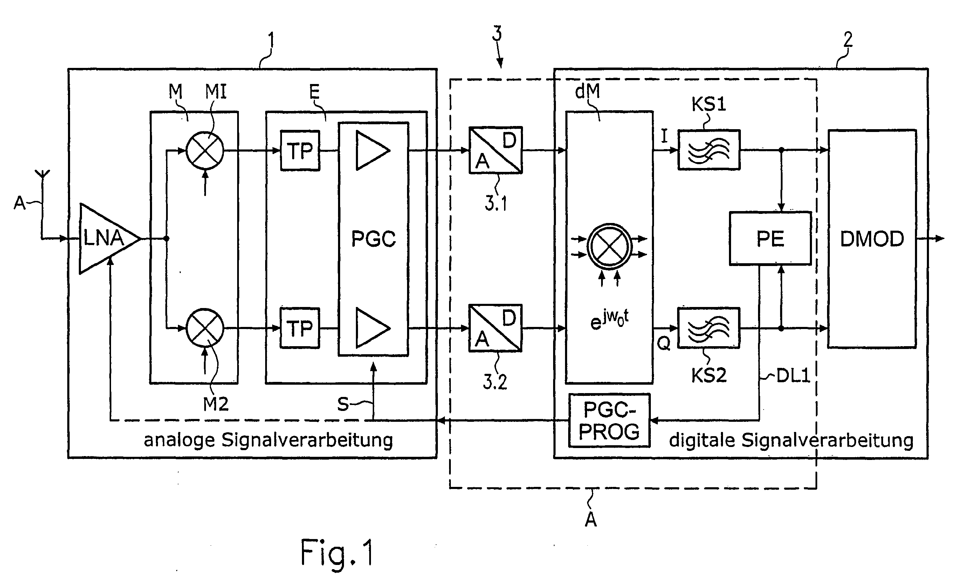

Fig. 1 zeigt in Form eines Blockschaltbilds in beispielhafter Weise den Aufbau einer erfindungsgemäßen Empfangsschaltung. Die Empfangsschaltung kann in schnurlosen digitalen Kommunikationssystemen (z.B. DECT, WDCT, Bluetooth, SWAP, WLAN usw.) eingesetzt werden.

Die Empfangsschaltung weist ein empfangsseitig angeordnetes Schaltungsteil 1, in welchem eine analoge Signalverarbeitung durchgeführt wird, ein ausgangsseitig angeordnetes Schaltungsteil 2, in welchem die Signalverarbeitung digital erfolgt, und eine Analog-Digital-Umsetzerstufe 3 auf, welche im Signalweg zwischen dem analogen Schaltungsteil 1 und dem digitalen Schaltungsteil 2 vorgesehen ist.

Ein Funksignal wird von einer Antenne A aufgefangen und einem rauscharmen Eingangsverstärker LNA zugeführt. Die Verstärkung des LNA kann einstellbar ausgeführt sein, so daß der LNA gleichzeitig, wie in Fig. 1 dargestellt, die vorderste Stufe der PGC darstellt. Der Eingangsverstärker LNA verstärkt das hochfrequente Antennensignal. Ein Ausgangssignal des Verstärkers LNA wird einer Hochfrequenz-Mischstufe M zugeführt. Die HF-Mischstufe M umfaßt zwei Mischer M1, M2, welche das verstärkte Hochfrequenzsignal in einen Zwischenfrequenzbereich heruntermischen. Die Mischer M1 und M2 werden in bekannter Weise unter einem Phasenversatz von 90° mit einer einstellbaren Mischfrequenz betrieben. An ihren Ausgängen steht jeweils ein analoges Zwischenfrequenzsignal (Inphase-Zweig bzw. Quadratur-Zweig) bereit.

Der HF-Mischstufe M ist eine Einheit E zur Vorfilterung und Verstärkung der von der HF-Mischstufe M empfangenen Zwischenfrequenzsignale nachgeschaltet. Die Einheit E weist eingangsseitig für jeden Signalzweig ein analoges Tiefpaßfilter TP auf, das in der Technik auch als Anti-Aliasing-Filter bezeichnet wird.

Die Ausgänge der beiden Tiefpaßfilter TP werden jeweils einer PGC zugeführt. Die Verstärkung beider PGCs ist variabel und kann über einen gemeinsamen Steuersignaleingang, dem ein gemeinsames Steuersignal S zugeführt wird, eingestellt werden. Da es sich bei dem Steuersignal S um ein digitales Steuerwort handelt, wird die Einstellung der Verstärkung der PGC auch als Programmierung bezeichnet.

Jede PGC ist in nicht dargestellter Weise aus mehreren hintereinander geschalteten Verstärkerstufen einer konstanten aber nicht notwendigerweise identischen Verstärkung aufgebaut. Die Verstärkungseinstellung erfolgt dann durch einfaches Zu- bzw. Abschalten einer Verstärkerstufe in Abhängigkeit von einer Anweisung durch das Steuersignalwort S.

Die Ausgänge der beiden PGC stellen gleichzeitig die Ausgänge des analogen Schaltungsteils 1 dar.

Die genannten Ausgänge werden jeweils einem Analog-Digital-Umsetzer 3.1 bzw. 3.2 zugeführt. Die beiden Analog-Digital-Umsetzer 3.1 und 3.2 realisieren die Analog-Digital-Umsetzerstufe 3. An den Ausgängen der Analog-Digital-Umsetzer 3.1, 3.2 wird ein digitales Zwischenfrequenzsignal ausgegeben, dessen Bandbreite allein durch das Tiefpaßfilter TP eingeschränkt ist. D.h., daß die von der Analog-Digital-Umsetzerstufe 3 ausgegebenen digitalen Zwischenfrequenzsignale mehrere, insbesondere auch sämtliche verfügbaren Benutzerkanäle überdecken können.

Die Ausgänge der Analog-Digital-Umsetzer 3.1 bzw. 3.2 werden einem komplexen, digitalen Zwischenfrequenz-(ZF-)Mischer dM zugeführt. Der digitale ZF-Mischer dM multipliziert die digitalen Signalwerte mit einem Phasensignal exp(jw₀t) der Kreisfrequenz w₀. In diesem Ausdruck bezeichnet t die Zeit und j die imaginäre Einheit. Der digitale ZF-Mischer dM verschiebt die Frequenzlage des empfangenen digitalen Signals um die i.a. feste Frequenz w₀/2π.

Der digitale Mischer dM weist zwei Ausgänge auf, an denen breitbandige, digitale Empfangssignale des I-Zweigs und des Q-Zweigs ausgegeben werden.

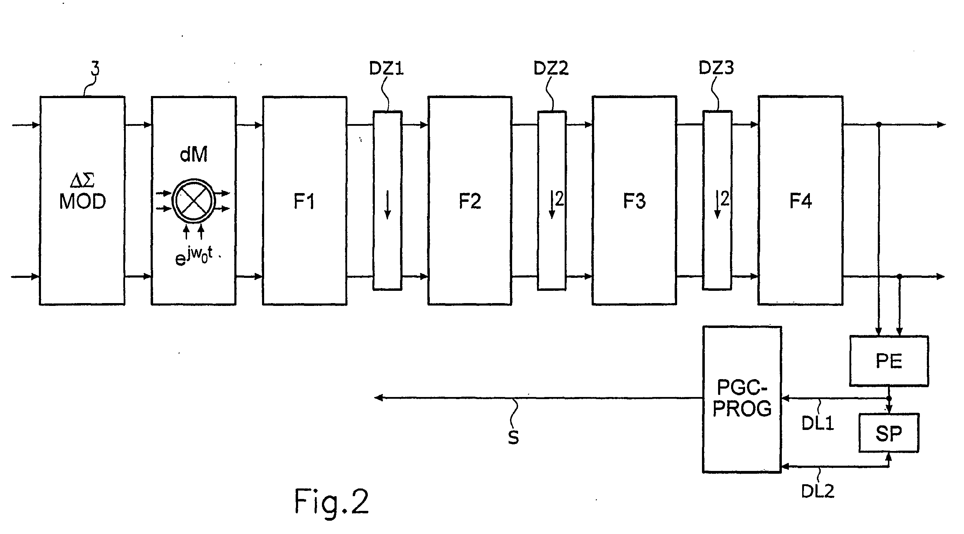

Im Signalweg hinter dem digitalen Mischer dM ist in jedem Signalzweig eine Kanalselektions- und Dezimationsstufe KS1 bzw. KS2 vorgesehen. Die beiden Kanalselektions- und Dezimationsstufen KS1, KS2 sind baugleich und werden in Zusammenhang mit Fig. 2 noch näher beschrieben. Am Ausgang jeder der beiden Stufen KS1 bzw. KS2 wird ein digitales Signal ausgegeben, dessen Bandbreite auf die Kanalbandbreite begrenzt ist und eine gegenüber der Abtastrate der Analog-Digital-Umsetzer 3.1 bzw. 3.2 erniedrigte Signalrate (Datensymbolrate) aufweist. Die Abstimmung dieses Signals auf einen gewünschten Nutzkanal erfolgt mittels der analogen, einstellbaren Mischer M1, M2.

Die beiden Ausgänge der Kanalselektions- und Dezimationsstufen KS1, KS2 werden in einen digitalen Demodulator DMOD eingespeist, welcher die Signale entsprechend dem der Signalübertragung zugrundeliegenden Standard in bekannter Weise demoduliert. Die Demodulation kann beispielsweise eine adaptive Kanalschätzung, eine Entzerrung, eine Kanaldecodierung usw. umfassen. In nicht dargestellter Weise wird das demodulierte Signal nachfolgend geeignet weiter verarbeitet, d.h. z.B. entschachtelt, quellendecodiert, in ein analoges Signal umgesetzt, verstärkt und einer geeigneten Ausgabeeinheit (z.B. Lautsprecher, Monitor) zugeführt.

Die Ausgänge der beiden Kanalselektions- und Dezimationsstufen KS1, KS2 stehen ferner mit einem Leistungsschätzer PE in Verbindung. Der Leistungsschätzer PE nimmt auf der Basis der erhaltenen digitalen Signale des I- und des Q-Zweigs eine Leistungsschätzung in dem Nutzkanal vor. Das Ergebnis dieser Leistungsschätzung (d.h. ein digital codierter Wert, der die im Nutzkanal gemessene Leistung bezeichnet) wird einer PGC-Programmiereinheit PGC-PROG über eine Datenleitung DL1 mitgeteilt.

Anstelle der Leistungsschätzung kann auch eine andere Form der Signalstärkenbewertung, z.B. die Ermittlung einer Empfangsfeldstärke, eines Signal-Spannungspegels usw. vorgenommen werden.

Die PGC-Programmiereinheit PGC-PROG steuert die PGC. Für den Fall, daß die PGC aus mehreren zu- bzw. abschaltbaren Verstärkerstufen aufgebaut ist, teilt die PGC-Programmiereinheit PGC-PROG dem PGC mit, wie viele Verstärkerstufen aktiviert werden sollen. Sofern die Verstärkerstufen unterschiedliche Verstärkungen haben, teilt das von der PGC-Programmiereinheit PGC-PROG ausgegebene Steuersignal der PGC auch mit, welche der Verstärkerstufen zu aktivieren bzw. zu deaktivieren sind.

Die Umschaltung der PGC auf eine größere Verstärkung (Zuschaltung einer Verstärkerstufe) erfolgt immer dann, wenn ein vorgegebenes minimales Signal-zu-Rauschverhältnis im bandbreitenbegrenzten Nutzkanalsignal unterschritten wird. Als minimales Signal-zu-Rauschverhältnis kann ein Schwellenwert definiert werden, welcher gewährleistet, daß eine maximale Bitfehlerrate z.B. am Ausgang des digitalen Demodulators DMOD nicht überschritten wird. Durch die Steuerung der Schaltpunkte der PGC in Abhängigkeit von der im Nutzkanal gemessenen Leistung, der im Nutzkanal auftretenden Rauschleistung und dem vorgegebenen Schwellenwert wird erreicht, daß eine Umschaltung der PGC nur dann vorgenommen wird, wenn diese - unter dem Gesichtspunkt einer nicht mehr akzeptablen Bitfehlerrate - zwingend erforderlich ist. Im Ergebnis wird dadurch erreicht, daß nur eine minimale Anzahl von Umschaltpunkten über den gesamten Leistungsbereich auftritt. Dies ermöglicht auf der anderen Seite, eine PGC mit einer geringstmöglichen Anzahl von Verstärkerstufen einzusetzen.

Das Signal-zu-Rauschverhältnis wird in der PGC-Programmiereinheit PGC-PROG aus dem über die Datenleitung DL1 mitgeteilten Leistungswert und einer Rauschleistung berechnet. Die Rauschleistung (bzw. der Rauschpegel) ist durch das Eingangsrauschen des Empfängers und das Eigenrauschen des analogen Schaltungsteils 1 des Empfängers, d.h. der Dimensionierung des analogen Signalpfads, bestimmt. Die Rauschleistung ist dabei abhängig von der gewählten Verstärkung der PGC. Zu jeder möglichen Programmierung der PGC ist in der PGC-Programmiereinheit PGC-PROG ein Wert für die entsprechende Rauschleistung abgespeichert. Das in dem Nutzkanal auftretende Signal-zu-Rauschverhältnis wird dann durch Quotientenbildung des von dem Leistungsschätzer PE ausgegebenen Leistungswerts mit dem in der PGC-Programmiereinheit PGC-PROG bezüglich der gewählten Programmierung abgespeicherten Rauschleistungswert berechnet. Eine andere Möglichkeit besteht darin, die Rauschleistung im Nutzkanal durch direkte Messung zu bestimmen.

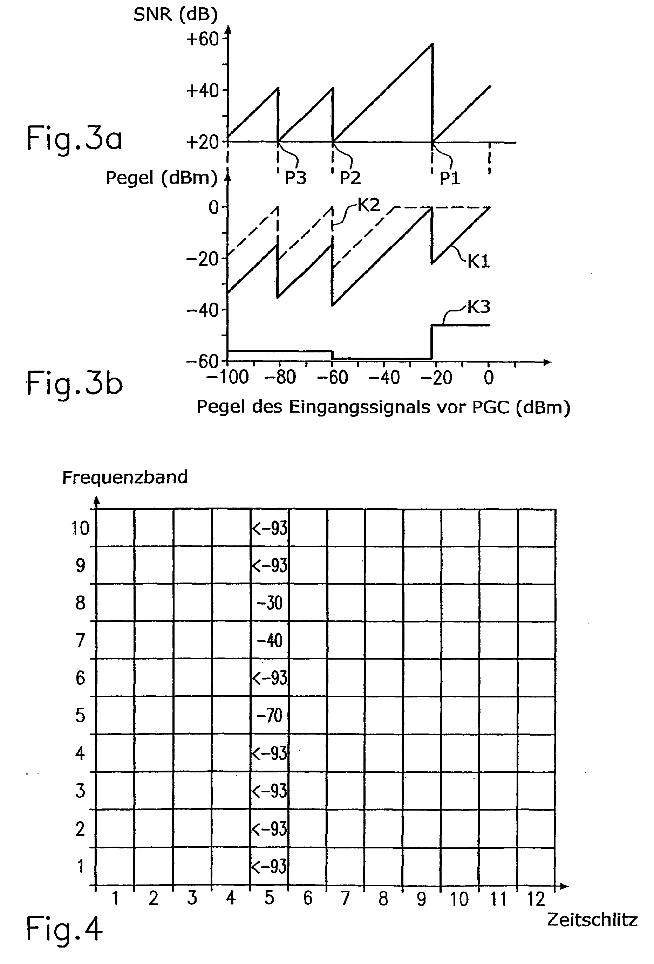

Zur Erläuterung der erfindungsgemäßen Zu- bzw. Abschaltung von Verstärkerstufen wird auf die Figuren 3a und 3b Bezug genommen. In Fig. 3a ist das logarithmische Signal-zu-Rauschverhältnis SNR (in dB) über dem logarithmischen Verhältnis des Pegels des Eingangssignals vor der PGC zu dem maximal zulässigen Signalpegel dieses Eingangssignals (in dBm) aufgetragen. Das minimal zulässige Signal-zu-Rauschverhältnis beträgt in diesem Beispiel 20 dB. Ausgehend von einer maximalen Signalstärke (Aussteuerungsgrenze) bei 0 dBm am Eingang der PGC erfolgt die Zuschaltung einer Verstärkerstufe immer dann, wenn das Signal-zu-Rauschverhältnis kleiner als 20 dB wird, d.h. an den Umschaltpunkten P1, P2, P3. Zur Durchführung des erläuterten Verfahrens ist eine vier Verstärkerstufen umfassende PGC ausreichend.

In Fig. 3b sind der Pegel des Signals im Nutzkanal hinter der Kanalselektions- und Dezimationsstufe KS1 bzw. KS2 (Kurve K1), der Pegel des (breitbandigen) Gesamtsignals hinter der PGC (Kurve K2) sowie der (verstärkungsabhängige) Rauschpegel (Kurve K3) im Nutzkanal gegenüber dem Pegel des Eingangssignals vor der PGC (jeweils in dBm) dargestellt (die beiden Schaubilder der Fig. 3a und 3b weisen eine gemeinsame x-Achse auf). Es wird deutlich, daß bei jeder Zuschaltung einer Verstärkerstufe eine sprunghafte Erhöhung des Nutzsignalpegels (Kurve K1) auftritt. Gegenteiliges gilt bei der Deaktivierung einer Verstärkerstufe bei steigendem Pegel des Eingangssignals.

Die Kurve K3 macht deutlich, daß sich der Rauschpegel im Nutzkanal nicht notwendigerweise bei Abschaltung einer Verstärkerstufe reduzieren muß. Da eine Verstärkerstufe das Rauschen der im Signalpfad vor ihr liegenden Funktionsblöcke mitverstärkt, ist bei Abschalten einer Verstärkerstufe zwar grundsätzlich mit einer Verminderung des Gesamtrauschens zu rechnen. Beim Punkt P3 ist dieser Effekt aber nicht signifikant, da dort (in dem speziellen, dargestellten Beispiel) die Verstärkung in der vordersten Verstärkerstufe geändert wird. Am Punkt P2 ist eine Rauschreduzierung festzustellen, da eine mittlere Verstärkerstufe herausgenommen wird. Die Verstärkereinstellung am Punkt P1 erfolgt (im konkreten Beispiel) durch eine Änderung der Verstärkung einer Schalter-Kondensatorrealisierung, die die hinterste Verstärkerstufe bildet. Diese Verstärkerstufe weist bei kleiner Verstärkereinstellung ein deutlich größeres Eigenrauschen auf, so daß sich das resultierende Gesamtrauschen im Empfangspfad (sogar) erhöht.

Bei der Umschaltung der PGC muß beachtet werden, daß die Grö-ße der zugeschalteten Verstärkung (bei abfallendem Eingangssignalpegel) so gewählt sein muß, daß das breitbandige Gesamtsignal hinter der PGC zu keiner Übersteuerung der Analog-Digital-Umsetzer 3.1 bzw. 3.2 führt. Da sich das Gesamtsignal hinter der PGC aus dem Nutzsignal und möglichen (ggf. größeren) Signalen in Nachbarkanälen zusammensetzt, ist es für eine sichere Vermeidung von Übersteuerungen am Eingang der Analog-Digital-Umsetzer 3.1. bzw. 3.2 nicht ausreichend, allein die Leistung im Nutzsignal (gemäß der von dem Leistungsschätzer PE ausgegebenen Information) zu bewerten.

Eine Möglichkeit zur Verhinderung einer Übersteuerung der Analog-zu-Digital-Umsetzer 3.1, 3.2 besteht darin, die Signalleistungen von Nachbarkanälen einer Kanalliste zu entnehmen. Zur Erläuterung dieser Möglichkeit wird auf die Fig. 2 und 4 Bezug genommen.

In Fig. 2 ist der mit einer gestrichelten Linie umrandete Ausschnitt A der in Fig. 1 dargestellten Empfangsschaltung detaillierter dargestellt. Das digitale Schaltungsteil 2 weist einen Speicher SP auf, dessen Eingang mit dem Ausgang des Leistungsschätzers PE in Verbindung steht. Ein Ausgang des Speichers SP ist über eine Datenleitung DL2 mit der PGC-Programmiereinheit PGC-PROG verbunden.

Mittels der einstellbaren Mischstufe M wird in regelmäßigen Zeitabständen ein sogenannter RSSI-Scan durchgeführt, bei dem die Signalstärke (bzw. Leistung) in allen verfügbaren Kanälen bestimmt und in eine Liste eingetragen wird, welche von dem Speicher SP verwaltet wird. Ein Beispiel für eine derartige Kanalliste ist in Fig. 4 dargestellt. Dem Beispiel liegt ein FDMA/TDMA-Vielfachzugriffsystem mit zehn verfügbaren Frequenzbändern (Kanälen) und zwölf Zeitschlitzen zugrunde. In dem dargestellten Beispiel soll nun ein Nutzsignal im Frequenzband 5 innerhalb des Zeitschlitzes 5 empfangen werden. In der Kanalliste sind die Signalstärkenwerte aller verfügbaren Kanäle, die bei dem RSSI-Scan von dem Leistungsschätzer PE ermittelt wurden, in der Einheit dBm eingetragen. Kanäle mit Signalstärken kleiner als z.B. -96 dBm werden in der Liste als freie Kanäle gekennzeichnet. Frei sind demnach die Kanäle 1 bis 4, 6, 9 und 10. Kanäle, in denen größere Signale gemessen werden (Kanäle 5, 7, 8), werden als belegt markiert.

Üblicherweise wird die Kanalliste lediglich dafür verwendet, herauszufinden, welche Kanäle frei sind und somit für einen möglichen Handover zur Verfügung stehen. Beim dargestellten Erfindungsbeispiel wird die in der Kanalliste enthaltene Information darüber hinaus dafür verwendet, eine Übersteuerung des Eingangs der Analog-Digital-Umsetzerstufe 3 auszuschlie-ßen.

Zu diesem Zweck liest die PGC-Programmiereinheit PGC-PROG immer dann, wenn aufgrund eines zu niedrigen Signal-zu-Rauschverhältnisses die Verstärkung in der PGC zu erhöhen ist, die in der Kanalliste für den Zeitschlitz 5 eingetragenen Signalstärkenwerte aus und ermittelt den größten Signalwert, im vorliegenden Fall -30 dBm im Kanal 8. Die Verstärkung der PGC wird dann über das Steuersignal S so eingestellt, daß auch unter Berücksichtigung des größten Störsignals (Kanal 8) keine Übersteuerung am Eingang der Analog-zu-Digital-Umsetzerstufe 3 auftritt. Insbesondere kann diejenige Verstärkerstufe ausgewählt und zugeschaltet werden, die unter denjenigen Verstärkerstufen, die bei einer Zuschaltung keine Übersteuerung der Analog-zu-Digital-Umsetzer 3.1 bzw. 3.2 bewirken würden, die maximale Verstärkung aufweist.

Würden Nachbarstörsignale (Kanäle 7 und 8) einer größeren Signalstärke als das Nutzsignal (Kanal 5) bei der Einstellung der PGC nicht berücksichtigt werden, würde insbesondere im Falle eines schwachen Empfangssignals im Nutzkanal eine Übersteuerung der Analog-Digital-Umsetzer 3.1, 3.2 auftreten können.

Eine Abschaltung einer Verstäkerstufe kann ebenfalls anhand der in der Kanalliste abgespeicherten Signalstärkenwerte vorgenommen werden, und zwar immer dann, wenn ein Signalpegelwert in der Liste auftaucht, der anzeigt, daß die Analog-Digital-Umsetzerstufe übersteuert wird, d.h. der einen maximalen Wert annimmt. Sofern ein zusätzlicher Signalpegelschätzer am Eingang (für einen AGC) oder am Ausgang (für einen PGC) der Analog-Digital-Umsetzerstufe 3 vorgesehen ist, kann natürlich auch dieser zur Initiierung einer Abschaltung einer Verstärkerstufe eingesetzt werden.

In Fig. 2 ist die Analog-Digital-Umsetzerstufe 3 in Verbindung mit den Tiefpaßfiltern TP aus Fig. 1 näher dargestellt. Die Analog-Digital-Umsetzung wird durch einen Delta-Sigma-Modulator MOD der Ordnung L und die Kanalfilterung durch eine Kaskade bestehend aus drei Dezimationsstufen DZ1, DZ2, DZ3 sowie vier Filterstufen F1, F2, F3, F4 durchgeführt. Die Filterstufen F1, F2, F3, F4 und die Dezimationsstufen DZ1, DZ2, DZ3 sind alternierend angeordnet, so daß von Filterstufe zu Filterstufe jeweils eine Abtastratenreduzierung beispielsweise um den Faktor 2 erfolgt.

Die im Signalweg eingangsseitig angeordnete Filterstufe F1 kann durch ein sogenanntes sinc^{k}-Filter der L+1-ten Ordnung realisiert sein. Die beiden nachfolgenden Filterstufen F2 und F3 werden durch minimalphasige Brückenwellen- bzw. Wellendigitalfilter realisiert. Beispielsweise kann es sich bei der zweiten Filterstufe F2 um ein bireziprokes Wellendigitalfilter und bei der dritten Filterstufe F3 um ein Brückenwellendigitalfilter handeln.

Die ausgangsseitige Filterstufe F4 kann in Form eines einfachen Dämpfungsfilters (Equalizer-Filter) realisiert sein. Dieses Filter F4 dient dazu, Gruppenlaufzeitverzerrungen, die durch die vorgeschalteten rekursiven Filter entstehen, auszugleichen.

Im Vergleich zu linearphasigen FIR-Filtern zeichnen sich die minimalphasigen Brückenwellen- bzw. Wellendigitalfilter F2 und F3 dadurch aus, daß sie eine minimale Gruppenlaufzeit aufweisen. Außerdem ist der Realisierungsaufwand dieser Filter F2 und F3 deutlich geringer als derjenige von FIR-Filter. Das dargestellte Filterkonzept weist somit deutliche Vorteile gegenüber einer Filterkaskade auf, welche FIR-Filter einsetzt.

Im Vergleich zu einem Flash-Analog-zu-Digital-Umsetzer mit nachgeschalteter FIR-Filterkaskade weist die in Fig. 2 dargestellte Anordnung (Delta-Sigma-Modulator MOD, F1, DZ1, F2, DZ2, F3, DZ3, F4) darüber hinaus einen reduzierten Realisierungsaufwand im Bereich der Analog-Signalverarbeitung (d.h. bei dem Delta-Sigma-Modulator MOD) auf.

Ergänzend wird noch darauf hingewiesen, daß mittels der PGC-Programmiereinheit PGC-PROG in optionaler Weise auch eine Einstellung der Verstärkung des rauscharmen Eingangsverstärkers LNA vorgenommen werden kann. In diesem Fall wird bei der Auswahl einer Verstärkungsstufe der PGC auch die gewählte Verstärkung des rauscharmen Eingangsverstärkers LNA berücksichtigt. Eine von der PGC-Programmiereinheit PGC-PROG zu dem rauscharmen Eingangsverstärker verlaufende Daten-Steuerleitung ist in Fig. 1 mit DL3 bezeichnet.

## Patentansprüche

1. Empfangsschaltung für einen Mobilfunkempfänger, bei welcher im Signalweg in der folgend genannten Reihenfolge angeordnet sind:
- ein steuerbarer Verstärker (PGC) variabler Verstärkung,
- eine Analog-Digital-Umsetzerstufe (3),
- eine Digitalfilteranordnung (KS1, KS2) zur Kanalselektion, und
- ein Signalstärkenschätzer (PE) zur Ermittlung der Signalstärke im selektierten Nutzkanal, und wobei
- der Verstärker (PGC) in Abhängigkeit von der vom Signalstärkenschätzer ermittelten Nutzkanal-Signalstärke steuerbar ist,
**dadurch gekennzeichnet,**
- **daß** die Empfangsschaltung ein Speichermittel (SP) aufweist, in welchem von dem Signalstärkenschätzer (PE) ermittelte Signalstärkenwerte für den Nutzkanal und die jeweiligen Signalstärkenwerte für Nachbarkanäle abspeicherbar sind, und
- **daß** die Empfangsschaltung eine Auswerteeinrichtung (PGC-PROG) aufweist, welche die in dem Speichermittel (SP) abgelegten Signalstärkenwerte auslesen kann und anhand der Signalstärkenwerte für den Nutzkanal und der Signalstärkenwerte für die Nachbarkanäle den Verstärker (PGC) derart steuert, daß das am Eingang der Analog-Digital-Umsetzerstufe (3) anliegende Signal die Analog-Digital-Umsetzerstufe (3) nicht übersteuert.

2. Empfangsschaltung nach Anspruch 1,
**dadurch gekennzeichnet,**
- **daß** der steuerbare Verstärker (PGC) aus mehreren Verstärkerstufen aufgebaut ist,
- **daß** der Auswerteeinrichtung (PGC-PROG) die von dem Signalstärkenschätzer ermittelte Nutzkanal-Signalstärke mitgeteilt wird, und
- **daß** eine Zuschaltung einer Verstärkerstufe immer dann vorgenommen wird, wenn die Auswerteeinrichtung (PGC-PROG) feststellt, daß ein vorgegebenes Signal-zu-Rauschverhältnis im Nutzsignal unterschritten wird.

3. Empfangsschaltung nach Anspruch 1 oder 2,
**dadurch gekennzeichnet,**
- **daß** die Digitalfilteranordnung (KS1, KS2) zur Kanalselektion als Kaskade bestehend aus mehreren Filterstufen (F1, F2, F3, F4) aufgebaut ist, und
- **daß** bis auf die eingangsseitige und gegebenenfalls die ausgangsseitige Filterstufe minimalphasige Filterstufen, insbesondere Wellendigitalfilter und/oder Brückenwellendigitalfilter, eingesetzt werden.

4. Empfangsschaltung nach Anspruch 2,
**dadurch gekennzeichnet,**
- **daß** das vorgegebene Signal-zu-Rauschverhältnis etwa 20 dB beträgt.

5. Empfangsschaltung nach Anspruch 2,
**dadurch gekennzeichnet,**
- **daß** zumindest einige Verstärkerstufen des steuerbaren Verstärkers unterschiedliche Verstärkungen aufweisen, und
- **daß** bei Zuschaltung einer Verstärkerstufe die Wahl dieser Verstärkerstufe in Abhängigkeit von den aus dem Speichermittel (SP) ausgelesenen Signalstärkenwerten vorgenommen wird.

6. Empfangsschaltung nach Anspruch 2,
**dadurch gekennzeichnet,**
- **daß** der steuerbare Verstärker (PGC) zwischen 3 und 6, insbesondere 4, Verstärkerstufen aufweist.

7. Empfangsschaltung nach einem der vorhergehenden Ansprüche,
**dadurch gekennzeichnet,**
- **daß** die Analog-Digital-Umsetzerstufe (3) durch einen Delta-Sigma-Umsetzer (MOD) realisiert ist.

8. Empfangsschaltung nach einem der vorhergehenden Ansprüche,
**dadurch gekennzeichnet,**
- **daß** im Signalweg zwischen der Analog-Digital-Umsetzerstufe (3) und der Digitalfilteranordnung (KS1, KS2) eine digitale ZF-Mischstufe (dM) angeordnet ist.

9. Verfahren zum Verarbeiten eines empfangenen Signals in einem Mobilfunkempfänger, mit den Schritten:
- Verstärken des empfangenen Signals mittels eines steuerbarer Verstärkers (PGC) variabler Verstärkung;
- Digitalisieren des verstärkten Signals mittels einer Analog-Digital-Umsetzerstufe (3);
- Bandbreitenbegrenzen des digitalisierten Signals mittels einer Digitalfilteranordnung (KS1, KS2) zur Kanalselektion; und
- Ermitteln der Signalstärke des selektierten Nutzkanal-Signals mittels eines Signalstärkenschätzers (PE); und wobei
- die Steuerung des Verstärkers (PGC) in Abhängigkeit von der vom Signalstärkenschätzer (PE) ermittelten Signalstärke im Nutzkanal vorgenommen wird,
**dadurch gekennzeichnet,**
- **daß** in einem Speichermittel (SP) Signalstärkenwerte für den Nutzkanal und die jeweiligen Signalstärkenwerte für Nachbarkanäle abgespeichert werden, und
- **daß** die abgespeicherten Signalstärkenwerte von einer Auswerteeinrichtung (PGC-PROG) aus dem Speichermittel (SP) ausgelesen werden, und
- **daß** die Auswerteeinrichtung (PGC-PROG) anhand der Signalstärkenwerte für den Nutzkanal und der Signalstärkenwerte für die Nachbarkanäle den Verstärker (PGC) derart steuert, daß das am Eingang der
Analog-Digital-Umsetzerstufe (3) anliegende Signal die Analog-Digital-Umsetzerstufe (3) nicht übersteuert.

10. Verfahren nach Anspruch 9,
**dadurch gekennzeichnet,**
- **daß** allein stufenweise Änderungen der Verstärkung realisierbar sind, und
- **daß** ein Übergang von einer Verstärkungsstufe in eine Verstärkungsstufe höherer Verstärkung dann vorgenommen wird, wenn ein vorgegebenes Signal-zu-Rauschverhältnis im Nutzkanal-Signal unterschritten wird.

## Claims

1. Receiver circuit for a mobile radio receiver in which the following are arranged in the signal path in the sequence specified below:
- a controllable amplifier (PGC) with a variable gain level,
- an analog-digital converter stage (3),
- a digital filter arrangement (KS1, KS2) for the purpose of channel selection, and
- a signal strength estimator (PE) for determining the signal strength in the selected user channel, and
- the amplifier (PGC) being controllable as a function of the user-channel signal strength determined by the signal strength estimator,
**characterized**
- **in that** the receiver circuit comprises a storage means (SP) in which signal strength values for the user channel determined by the signal strength estimator (PE) and the respective signal strength values for adjacent channels can be stored, and
- **in that** the receiver circuit comprises an evaluation device (PGC-PROG) which can read the signal strength values stored in the storage means (SP) and controls the amplifier (PGC) using the signal strength values for the user channel and the signal strength values for the adjacent channels in such a way that the signal present at the input of the analogue-digital converter stage (3) does not overdrive the analogue-digital converter stage (3).

2. Receiver circuit according to Claim 1, **characterized**
- **in that** the controllable amplifier (PGC) is composed of a plurality of amplifier stages,
- **in that** the user-channel signal strength determined by the signal strength estimator is communicated to the evaluation device (PGC-PROG), and
- **in that** an amplifier stage is connected into the circuit whenever the evaluation device (PGC-PROG) detects that the signal-to-noise ratio in the user signal has dropped below a predefined value.

3. Receiver circuit according to Claim 1 or 2, **characterized**
- **in that** the digital filter arrangement (KS1, KS2) is designed to perform a channel selection as a cascade composed of a plurality of filter stages (F1, F2, F3, F4), and
- **in that**, with the exception of the input end filter stage and, if appropriate, the output end filter stage, minimum-phase filter stages, in particular wave digital filters and/or bridge wave digital filters, are used.

4. Receiver circuit according to Claim 2, **characterized**
- **in that** the predefined signal-to-noise ratio is approximately 20 dB.

5. Receiver circuit according to Claim 2, **characterized**
- **in that** at least some amplifier stages of the controllable amplifier have different gain levels, and
- **in that**, when an amplifier stage is connected into the circuit, this amplifier stage is selected as a function of the signal strength values read out from the storage means (SP).

6. Receiver circuit according to Claim 2, **characterized**
- **in that** the controllable amplifier (PGC) has between 3 and 6, in particular 4, amplifier stages.

7. Receiver circuit according to one of the preceding claims, **characterized**
- **in that** the analog-digital converter stage (3) is implemented by means of a delta-sigma converter (MOD).

8. Receiver circuit according to one of the preceding claims, **characterized**
- **in that** a digital IF mixer stage (dM) is arranged in the signal path between the analog-digital converter stage (3) and the digital filter arrangement (KS1, KS2).

9. Method for processing a received signal in a mobile radio receiver, having the steps:
- the received signal is amplified by means of a controllable amplifier (PGC) with a variable gain;
- the amplified signal is digitized by means of an analog-digital converter stage (3);
- bandwidth limitation of the digitized signal is carried out by means of a digital filter arrangement (KS1, KS2) for the purpose of channel selection; and
- the signal strength of the selected user-channel signal is determined by means of a signal strength estimator (PE); and
- the amplifier (PGC) being controlled as a function of the user-channel signal strength determined by the signal strength estimator (PE),
**characterized**
**in that** signal strength values for the user channel and the respective signal strength values for adjacent channels are stored in a storage means (SP), and
- **in that** the stored signal strength values are read out from the storage means (SP) by an evaluation device (PGC-PROG), and
- **in that** the evaluation device (PGC-PROG) controls the amplifier (PGC) using the signal strength values for the user channel and the signal strength values for the adjacent channels in such a way that the signal present at the input of the analogue-digital converter stage (3) does not overdrive the analogue-digital converter stage (3) .

10. Method according to Claim 10, **characterized**
- **in that** only incremental changes in the gain level can be implemented, and
- **in that** a changeover from one amplification stage into an amplification stage with a higher gain level is carried out if the signal-to-noise ratio in the user-channel signal drops below a predefined value.

## Revendications

1. Circuit de réception pour un récepteur de téléphonie mobile, dans lequel il est monté dans le trajet du signal dans l'ordre mentionné dans ce qui suit:
- un amplificateur (PGC) pouvant être régulé de gain variable,
- un étage (3) de convertisseur analogique-numérique,
- un montage (KS1, KS2) de filtre numérique pour la sélection de canal, et
- un évaluateur (PE) de l'intensité du signal pour déterminer l'intensité du signal dans le canal utile sélectionné, et dans lequel
- l'amplificateur (PGC) peut être régulé en fonction de l'intensité du signal du canal utile déterminé par l'évaluateur de l'intensité du signal,
**caractérisé**
- **en ce que** le circuit de réception comporte un moyen (SP) de mémoire, dans lequel des valeurs d'intensité du signal pour le canal utile déterminées par l'évaluateur (PE) d'intensité du signal et les valeurs correspondantes d'intensité du signal pour des canaux voisins peuvent être mémorisées, et
- **en ce que** le circuit de réception a un montage (PGC-PROG) d'exploitation, qui peut lire les valeurs d'intensité du signal mémorisées dans le moyen (SP) de mémoire et qui régule, au moyen des valeurs d'intensité du signal pour le canal utile et des valeurs d'intensité du signal pour les canaux voisins, l'amplificateur (PGC) de façon à ce que le signal appliqué à l'entrée de l'étage (3) de convertisseur analogique-numérique ne surrégule pas l'étage (3) de convertisseur analogique-numérique.

2. Circuit de réception suivant la revendication 1,
**caractérisé**
- **en ce que** l'amplificateur (PGC) qui peut être régulé est constitué de plusieurs étages amplificateurs,
- **en ce qu'**il est communiqué au montage (PGC-PROG) d'exploitation les intensités de signal du canal utile déterminé par l'évaluateur d'intensité du signal, et
- **en ce qu'**il est effectué toujours une mise en circuit d'un étage amplificateur lorsque le montage (PGC-PROG) d'exploitation constate que l'on est passé dans le signal utile en dessous d'un rapport prescrit du signal au bruit.

3. Circuit de réception suivant la revendication 1 ou 2,
**caractérisé**
- **en ce que** le montage (KS1, KS2) de filtre numérique pour la sélection de canal est formé d'une cascade constituée de plusieurs étages (F1, F2, F3, F4) de filtre, et
- **en ce qu'**il est utilisé, à l'exception de l'étage de filtre du côté entrée et le cas échéant du côté sortie, des étages de filtre à phase minimum, notamment des filtres numériques d'onde et/ou des filtres numériques d'onde en pont.

4. Circuit de réception suivant la revendication 2,
**caractérisé**
- **en ce que** le rapport prescrit du signal au bruit est d'environ 20 dB.

5. Circuit de réception suivant la revendication 2,
**caractérisé**
- **en ce qu'**au moins certains étages de l'amplificateur pouvant être régulé ont des gains différents, et
- **en ce que**, lors de la mise en circuit d'un étage d'amplificateur, le choix de cet étage d'amplificateur est effectué en fonction des valeurs d'intensité du signal lu dans le moyen (SP) de mémoire.

6. Circuit de réception suivant la revendication 2,
**caractérisé**
- **en ce que** l'amplificateur (PGC) pouvant être régulé a entre trois et six et notamment quatre étages d'amplificateur.

7. Circuit de réception suivant l'une des revendications précédentes,
**caractérisé**
- **en ce que** l'étage (3) de convertisseur analogique-numérique est réalisé par un convertisseur delta-sigma (MOD).

8. Circuit de réception suivant l'une des revendications précédentes,
**caractérisé**
- **en ce qu'**un étage mixte ZF numérique (dM) est disposé dans le trajet du signal entre l'étage (3) de convertisseur analogique-numérique et le montage (KS1, KS2) de filtre numérique.

9. Procédé de traitement d'un signal reçu dans un récepteur de téléphonie mobile comprenant les stades :
- on amplifie le signal reçu au moyen d'un amplificateur (PGC) pouvant être régulé de gain variable ;
- on numérise le signal amplifié au moyen d'un étage (3) de convertisseur analogique-numérique,
- on limite la largeur de bande du signal numérisé au moyen d'un montage (KS1, KS2) de filtre numérique pour la sélection de canal, et
- on détermine l'intensité du signal du canal utile sélectionné au moyen d'un évaluateur (PE) d'intensité du signal ; et dans lequel
- on effectue la régulation de l'amplificateur (PGC) en fonction de l'intensité du signal dans le canal utile déterminé par l'évaluateur (PE) d'intensité du signal,
**caractérisé**
- **en ce que** l'on mémorise dans un moyen (SP) de mémoire des valeurs d'intensité du signal utile et les valeurs d'intensité du signal respectives pour des canaux voisins, et
- **en ce qu'**on lit les valeurs d'intensité du signal mémorisé par un montage (PGC-PROG) d'exploitation dans le moyen (SP) de mémoire, et
- **en ce que** le montage (PGC-PROG) d'exploitation régule, au moyen des valeurs d'intensité du signal pour le canal utile et des valeurs d'intensité du signal pour les canaux voisins, l'amplificateur (PGC) de façon à ce que le signal appliqué à l'entrée de l'étage (3) de convertisseur analogique-numérique ne surrégule pas l'étage (3) de convertisseur analogique-numérique.

10. Procédé suivant la revendication 9,
**caractérisé**
- **en ce que** l'on peut réaliser des modifications du gain seulement par palier, et
- **en ce que** l'on effectue un passage d'un étage d'amplification à un étage d'amplification de gain plus grand, seulement si on passe en dessous dans le signal du canal utile d'un rapport prescrit du signal au bruit.
